(19) Europäisches Patentamt / European Patent Office / Office européen des brevets

(11) **EP 2 506 439 B1**

(12) **EUROPEAN PATENT SPECIFICATION**

(45) Date of publication and mention
of the grant of the patent:
**05.05.2021   Bulletin 2021/18**

(51) Int Cl.:
**H03L 1/02** (2006.01)          **H03B 5/04** (2006.01)

(21) Application number: **12155265.7**

(22) Date of filing: **14.02.2012**

(54) **Frequency calibration system for higher order temperature compensation of a crystal oscillator**

Frequenzkalibriersystem für eine Temperaturkompensation höherer Ordnung eines Quartz.

Système d'étalonnage de fréquence pour la compensation en température d'ordre superior d'un oscillateur à quartz.

| | |
|---|---|
| (84) Designated Contracting States:<br>**AL AT BE BG CH CY CZ DE DK EE ES FI FR GB<br>GR HR HU IE IS IT LI LT LU LV MC MK MT NL NO<br>PL PT RO RS SE SI SK SM TR** | (72) Inventors:<br>• **Wang, Yi-Fong<br>Taipei City 114 (TW)**<br>• **Deng, Wei-Kung<br>Taipei City 114 (TW)** |
| (30) Priority:  **29.03.2011   TW 100110808** | (74) Representative: **Straus, Alexander et al<br>2K Patent- und Rechtsanwälte - München<br>Keltenring 9<br>82041 Oberhaching (DE)** |
| (43) Date of publication of application:<br>**03.10.2012   Bulletin 2012/40** | |
| (73) Proprietor: **RichWave Technology Corp.<br>Taipei City 114 (TW)** | (56) References cited:<br>GB-A- 2 121 629          JP-A- 8 116 214<br>US-A1- 2006 022 763     US-A1- 2008 007 363 |

**Description**

Field of the Invention

The present invention relates to a frequency calibration system according to the pre-characterizing clauses of claims 1.

Background of the Invention

Quartz is a naturally piezoelectric material. When an external voltage is applied to upper and lower sides of the quartz, the quartz generates mechanical deformation due to a coupling effect between mechanical and electrical characteristics of the quartz, resulting in a voltage drop being generated across the upper and lower sides of the quartz. If an alternating voltage is applied to the upper and lower sides of the quartz, the quartz can generate periodic oscillations. A crystal oscillator composed of quartz has an advantage of high frequency stability, so the crystal oscillator can act as a standard frequency source in various applications, including remote communications, mobile telephone systems, global positioning systems, navigation, remote controls, aerospace industries, high-speed computers, precision measurement instruments, consumer electronics, and other fields for providing accurate frequencies. The crystal oscillator needs a calibration circuit to compensate for a frequency error of the crystal oscillator that varies with the temperature.

Several calibration circuits have been proposed for compensating a frequency error of a crystal oscillator that varies with temperature, e.g. GB 2121629A, JP 8116214A, and US 2008/0007363A1. In GB 2121629A, a temperature compensated crystal oscillator in which the base emitter voltage of transistors in an integrated circuit is proposed to provide substantially linearly temperature sensitive outputs which are employed to generate a series of polynomial functions of Chebyshev-like form which are summed and used to control a varicap diode in the oscillator feedback path.

In JP 8116214A, a technique has been proposed to allow a generating circuit generating a signal proportional to a cubic or higher degree function in the function generator and the oscillation circuit with temperature compensation to generate a voltage changing with respect to a temperature in a way of the higher degree function thereby attaining desired temperature correction.

In US 2008/0007363A1, a function generation circuit is proposed. A first order function generation circuit of the function generation circuit receives a signal from a temperature sensor circuit, and generates a fist order function control signal that is affected by the ambient temperature. A fourth order and fifth order approximation function generation circuit of the function generation circuit receives signals from the temperature sensor circuit and from the third order approximation function generation circuit, and generates a fourth and fifth order approximation function control signal that is affected by the ambient temperature. A peak change point adjustment circuit of the function generation circuit outputs a signal to adjust the value of a peak change point temperature for the third order approximation function generation circuit, the first order generation function circuit and the fourth order and fifth order approximation function generation circuit. A temperature compensation circuit of the function generation circuit adds together the above mentioned control signals, and outputs the resultant signal.

US Patent Application No. 2006/0022763 discloses a temperature-compensated piezoelectric oscillator includes an AT-cut quartz crystal resonator, an amplifying circuit connected to one end of the quartz crystal resonator, a varactor diode connected to the other end of the quartz crystal resonator, and a temperature compensation voltage generation circuit connected to ends of the varactor diode via resistors. The temperature compensation voltage generation circuit includes a first voltage generation circuit that includes thermistors and resistors and that is connected to the cathode of the varactor diode, and a second voltage generation circuit that includes a thermistor and resistors and that is connected to the anode of the varactor diode.

Summary of the Invention

This in mind, the present invention aims at providing a temperature compensated frequency generating system that has lower design complexity and can increase compensation accuracy.

This is achieved by a temperature compensated frequency generation calibration system according to claims 1 which defines the inventions The dependent claims, which define further aspects of the invention, pertain to corresponding further developments and improvements.

In the detailed description following below, the claimed frequency generating system is explained in more details.

Brief Description of the Drawings

In the following, the invention is further illustrated by way of example, taking reference to the accompanying drawings. Thereof:

FIG. 1 is a diagram illustrating a frequency generated by the crystal oscillator varying with a temperature,

FIG. 2 is a diagram illustrating a frequency calibration system of a frequency generator according to an embodiment,

FIG. 3 is a diagram illustrating the first compensation unit group and the second compensation unit group according to an embodiment,

FIG. 4 is a diagram illustrating the first compensation unit group and the second compensation unit group according to an embodiment,

FIG. 5 is a diagram illustrating the first compensation unit group and the second compensation unit group according to an embodiment,

FIG. 6 is a diagram illustrating the second compensation signal, the third-order compensation signal, and the first-order compensation signal in FIG. 5 versus temperature,

FIG. 7 is a diagram illustrating a first compensation unit group and a second compensation unit group according to another embodiment,

FIG. 8 is a diagram illustrating a frequency generator according to another embodiment, and

FIG. 9 is a diagram illustrating a Gilbert-cell type multiplier.

Detailed Description

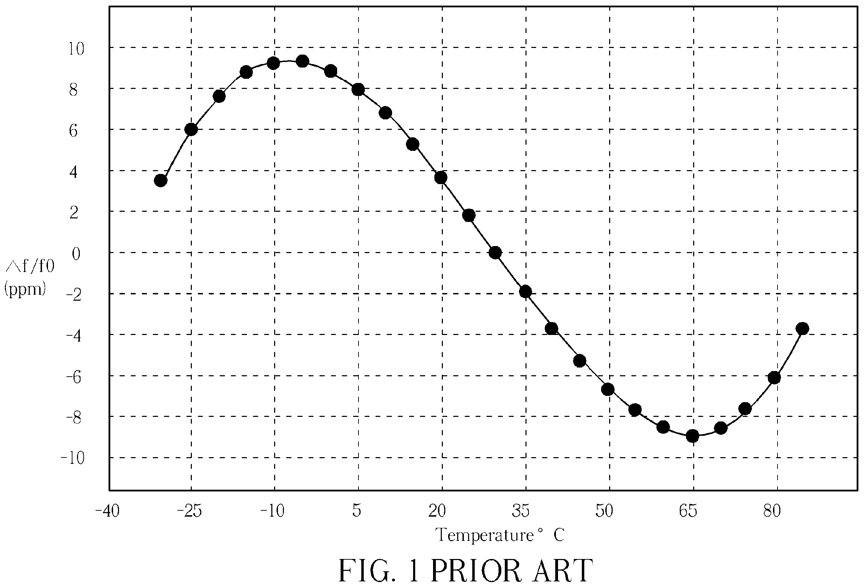

Please refer to FIG. 1. FIG. 1 is a diagram illustrating a frequency f generated by the crystal oscillator varying with a temperature. As shown in FIG. 1, the frequency f generated by the crystal oscillator shifts slightly from a target frequency f0 with the temperature, where a vertical axis in FIG. 1 is a ratio of a difference $\Delta f$ between the frequency f and the target frequency f0 to the target frequency f0. Therefore, the crystal oscillator needs a calibration circuit to compensate for a frequency error of the crystal oscillator that varies with the temperature.

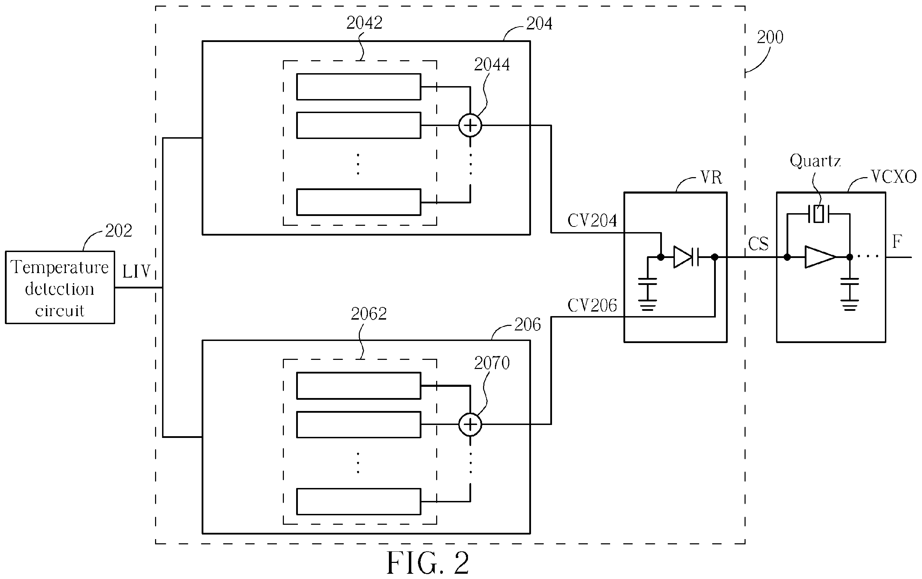

Please refer to FIG. 2. FIG. 2 is a diagram illustrating a frequency calibration system 200 of a frequency generator according to an embodiment. The frequency calibration system 200 includes two compensation circuits 204, 206 and a comparator VR. The two compensation circuits 204, 206 are used for describing the present invention, and the present invention is not limited to only the two compensation circuits 204, 206. A temperature detection circuit 202 is coupled to the two compensation circuits 204, 206 for detecting a temperature T to generate an input signal LIV, where a linear relationship exists between the input signal LIV and the temperature T. The two compensation circuits 204, 206 are coupled to the input signal LIV, and output a first compensation signal CV204 and a second compensation signal CV206 to the comparator VR, respectively, according to the input signal LIV. The comparator VR is coupled to the first compensation signal CV204 and the second compensation signal CV206, and outputs a calibration signal CS according to the first compensation signal CV204 and the second compensation signal CV206. The calibration signal CS is used for determining an oscillation frequency of a crystal oscillator VCXO, and the crystal oscillator VCXO is a crystal oscillator. The comparator VR is a varactor diode, and the comparator VR can change the calibration signal CS according to the first compensation signal CV204 and the second compensation signal CV206. Therefore, the frequency calibration system 200 can fine tune a frequency error of the crystal oscillator VCXO that varies with the temperature according to the calibration signal CS that varies with the temperature. In addition, the frequency calibration system 200 can include the temperature detection circuit 202 according to another embodiment.

As shown in FIG. 2, the compensation circuit 204 includes a first compensation unit group 2042 and a first adder 2044. The first compensation unit group 2042 includes n compensation units, and the first compensation unit group 2042 is coupled to the input signal LIV for outputting a first compensation unit signal group, where $n \geqq 1$. The first adder 2044 is coupled to the first compensation unit signal group for generating the first compensation signal CV204. The compensation circuit 206 includes a second compensation unit group 2062 and a second adder 2070. The second compensation unit group 2062 includes m compensation units for outputting a second compensation unit signal group, where $m \geqq 1$. The second adder 2070 is coupled to the second compensation unit signal group for generating the second compensation signal CV206. The n compensation units of the first compensation unit group 2042 and the m compensation units of the second compensation unit group 2062 can be combinations of compensation units of any order. But, the first compensation unit group 2042 and the second compensation unit group 2062 do not include a second-order compensation unit.

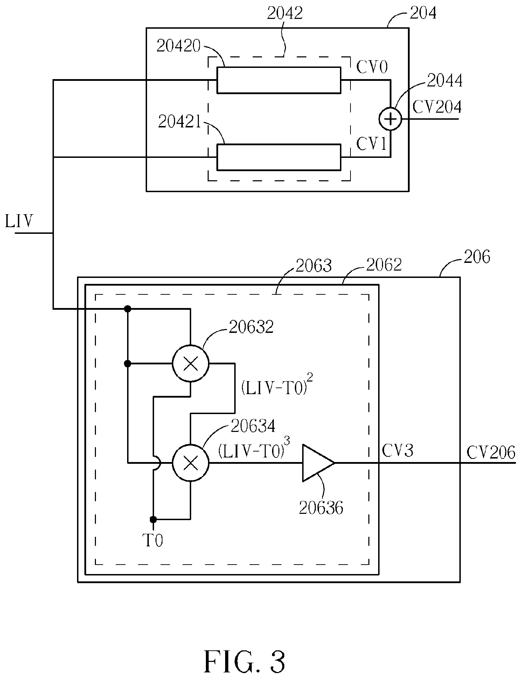

Please refer to FIG. 3, FIG. 4, and FIG. 5. FIG. 3, FIG. 4, and FIG. 5 are diagrams illustrating the first compensation unit group 2042 and the second compensation unit group 2062 according to different embodiments. As shown in FIG. 3, the first compensation unit group 2042 includes a zeroth-order compensation unit 20420, a first-order compensation unit 20421, and a first adder 2044, where the zeroth-order compensation unit 20420 is coupled to the input signal LIV for outputting a zeroth-order compensation signal CV0 according to the input signal LIV. The first-order compensation unit 20421 is coupled to the input signal LIV for outputting a first-order compensation signal CV1 according to the input signal LIV. The first adder 2044 is coupled to the zeroth-order compensation signal CV0 and the first-order compensation signal CV1 for generating the first compensation signal CV204. The second compensation unit group 2062 includes a third-order compensation unit 2063. The third-order compensation unit 2063 includes a first multiplier 20632, a second multiplier 20634, and a first amplifier 20636, where the third-order compensation unit 2063 is coupled to the input signal LIV for outputting a third-order compensation signal CV3 acting as the second compensation signal CV206. The first multiplier 20632 has a first terminal for receiving the input signal LIV, a second terminal for receiving the input signal LIV, a third terminal for receiving an adjustment parameter signal T0, and an output terminal for outputting a first signal $(LIV-T0)^2$. The second multiplier 20634 has a first terminal for receiving the input signal LIV, a second terminal for receiving the first signal $(LIV-T0)^2$, a third terminal for receiving the adjustment parameter signal T0, and an output terminal for outputting a second signal $(LIV-T0)^3$. The first amplifier 20636 has a first terminal coupled to the second multiplier 20634 for receiving the second signal $(LIV-T0)^3$, and an output terminal for outputting a third-order compensation signal CV3. In addition, a higher order compensation signal (a third-order compensation signal or a higher than third-order compensation signal) of the compensation circuit 204 can be generated according to equation (1):

$$CVj = COEF(j-2) \times (LIV-T0)^j \qquad (1)$$

As shown in equation (1), a (j-2)th coefficient COEF(j-2) is provided by a (j-2)th amplifier, where $j \geq 3$, and j is a positive integer.

Therefore, the third-order compensation signal CV3 can be represented by equation (2):

$$CV3 = COEF1 \times (LIV-T0)^3 \qquad (2)$$

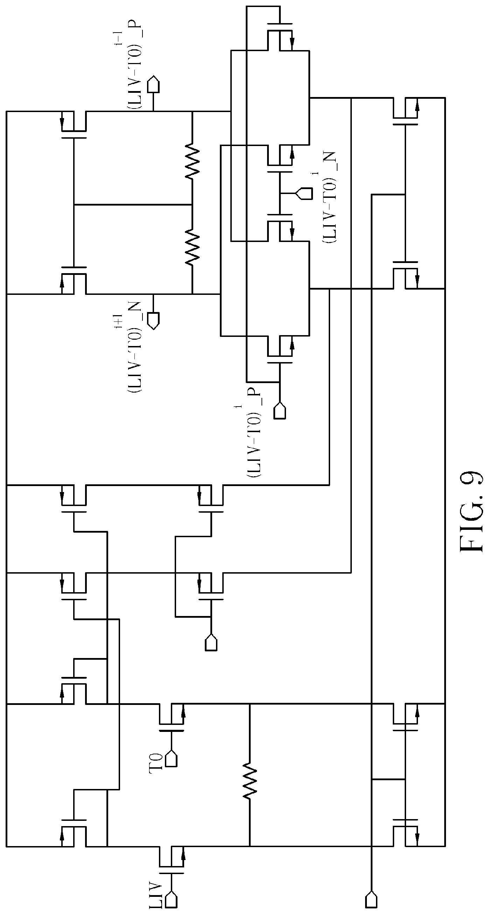

As shown in equation (2), a first coefficient COEF1 is provided by the first amplifier 20636, and the first coefficient COEF1 is a constant value. In addition, the first multiplier 20632 and the second multiplier 20634 are Gilbert-cell type multipliers (as shown in FIG. 9). In FIG. 3, the third-order compensation signal CV3 is the second compensation signal CV206.

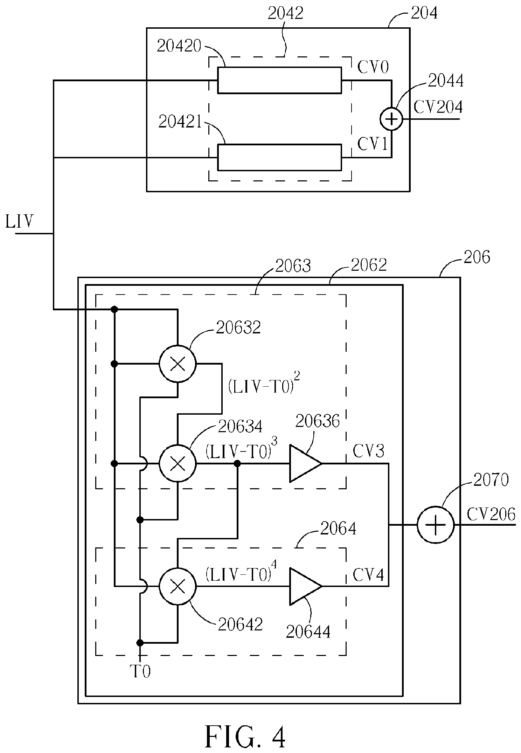

As shown in FIG. 4, the first compensation unit group 2042 includes the zeroth-order compensation unit 20420, the first-order compensation unit 20421, and the first adder 2044. In addition, the first compensation unit group 2042 is described in FIG. 3, so further descriptions thereof are omitted for simplicity. The second compensation unit group 2062 includes the third-order compensation unit 2063 and a fourth-order compensation unit 2064, where the third-order compensation unit 2063 is described in FIG. 3, so further descriptions thereof are omitted for simplicity. The fourth-order compensation unit 2064 includes a fourth multiplier 20642 and a second amplifier 20644. A second adder 2070 is coupled to the third-order compensation signal CV3 and a fourth-order compensation signal CV4 for generating a second compensation signal CV206. The fourth multiplier 20642 has a first terminal for receiving the input signal LIV, a second terminal for receiving the second signal $(LIV-T0)^3$, a third terminal for receiving the adjustment parameter signal T0, and an output terminal for outputting a third signal $(LIV-T0)^4$. The second amplifier 20644 has a first terminal coupled to the fourth multiplier 20642 for receiving the third signal $(LIV-T0)^4$, and an output terminal for outputting the fourth-order compensation signal CV4. The fourth-order compensation signal CV4 is generated according to equation (1), the third signal $(LIV-T0)^4$, and a second coefficient COEF2, where the second coefficient COEF2 is a variable coefficient. In addition, the fourth multiplier 20642 is a Gilbert-cell type multiplier (as shown in FIG. 9). In FIG. 4, the second compensation signal CV206 is generated by the second adder 2070 according to equation (3), the third-order compensation signal CV3, and the fourth-order compensation signal CV4:

$$CV206 = CV3 + CV4 = COEF1 \times (LIV-T0)^3 + COEF2 \times (LIV-T0)^4 \qquad (3)$$

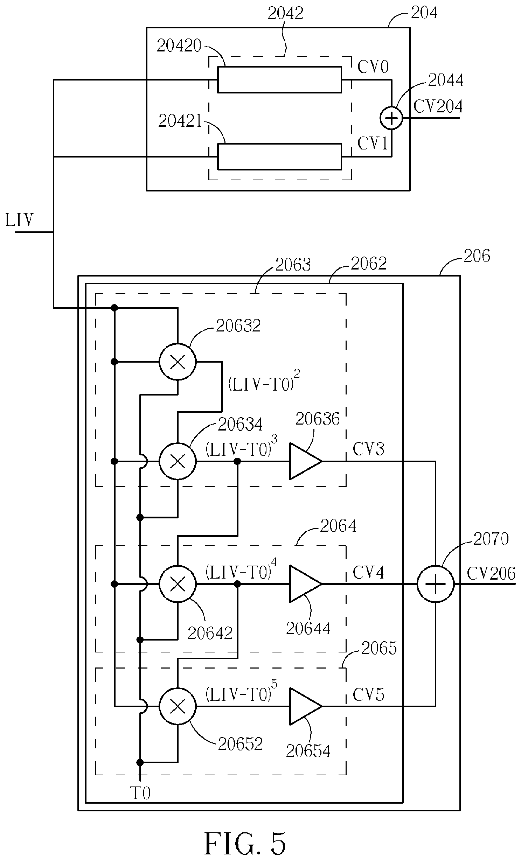

As shown in FIG. 5, the first compensation unit group 2042 includes the zeroth-order compensation unit 20420, the first-order compensation unit 20421, and the first adder 2044. In addition, the first compensation unit group 2042 is described in FIG. 3, so further description thereof is omitted for simplicity. The second compensation unit group 2062 includes the third-order compensation unit 2063, the fourth-order compensation unit 2064, a fifth-order compensation unit 2065, and the second adder 2070, where the second adder 2070 is coupled to the third-order compensation signal CV3, the fourth-order compensation signal CV4, and a fifth-order compensation signal CV5 for generating a second compensation signal CV206. The third-order compensation unit 2063 and the fourth-order compensation unit 2064 are described in FIG. 4, so further description thereof is omitted for simplicity. The fifth-order compensation unit 2065 includes a fifth multiplier 20652 and a third amplifier 20654. The fifth multiplier 20652 has a first terminal for receiving the input signal LIV, a second terminal for receiving the third signal $(LIV-T0)^4$, a third terminal for receiving the adjustment parameter signal T0, and an output terminal for outputting a fourth signal $(LIV-T0)^5$ The third amplifier 20654 has a first terminal coupled to the fifth multiplier 20652 for receiving the fourth signal $(LIV-T0)^5$, and an output terminal for outputting the fifth-order compensation signal CV5. The fifth-order compensation signal CV5 is generated according to equation (1), the fourth signal $(LIV-T0)^5$, and a third coefficient COEF3, where the third coefficient COEF3 is a variable coefficient. In addition, the fourth multiplier 20652 is a Gilbert-cell type multiplier (as shown in FIG. 9). In FIG. 5, the second compensation signal CV206 is generated by the second adder 2070 according to equation (4), the third-order compensation signal CV3, the fourth-order compensation signal CV4, and the fifth-order compensation signal CV5:

$$CV206 = CV3 + CV4 + CV5$$
$$= COEF1 \times (LIV - T0)^3 + COEF2 \times (LIV - T0)^4 + COEF3 \times (LIV - T0)^5 \quad (4)$$

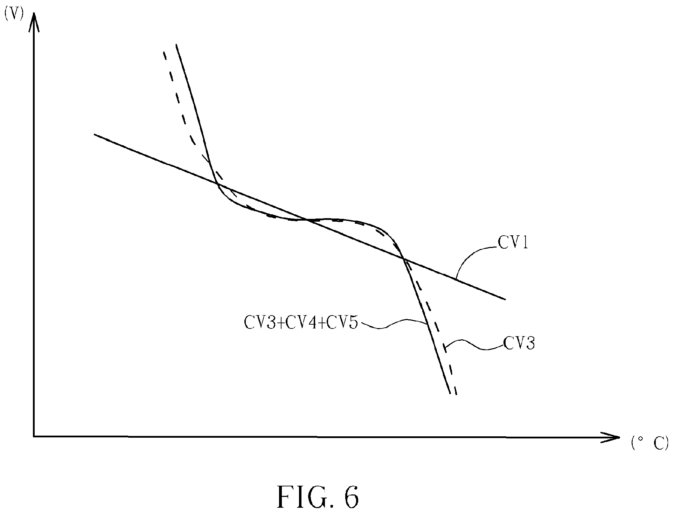

Please refer to FIG. 6. FIG. 6 is a diagram illustrating the second compensation signal CV206 (CV3+CV4+CV5), the third-order compensation signal CV3, and the first-order compensation signal CV1 in FIG. 5 versus the temperature. As shown in FIG. 6, the second compensation signal CV206, the third-order compensation signal CV3, and the first-order compensation signal CV1 vary with the temperature. Therefore, a user can flexibly adjust a plurality of compensation units included by the two compensation circuits 204, 206 to calibrate the frequency error of the crystal oscillator VCXO to vary exactly with the temperature according to the frequency error of the crystal oscillator VCXO that varies with the temperature.

In another embodiment, the first compensation unit group 2042 includes the zeroth-order compensation unit 20420 and the first-order compensation unit 20421. The second compensation unit group 2062 includes the third-order compensation unit 2063 to a kth-order compensation unit 206k, where k≧6. In addition, subsequent operational principles of the kth-order compensation unit 206k are the same as those of the fourth-order compensation unit 2064 and the fifth-order compensation unit 2065, so further description thereof is omitted for simplicity.

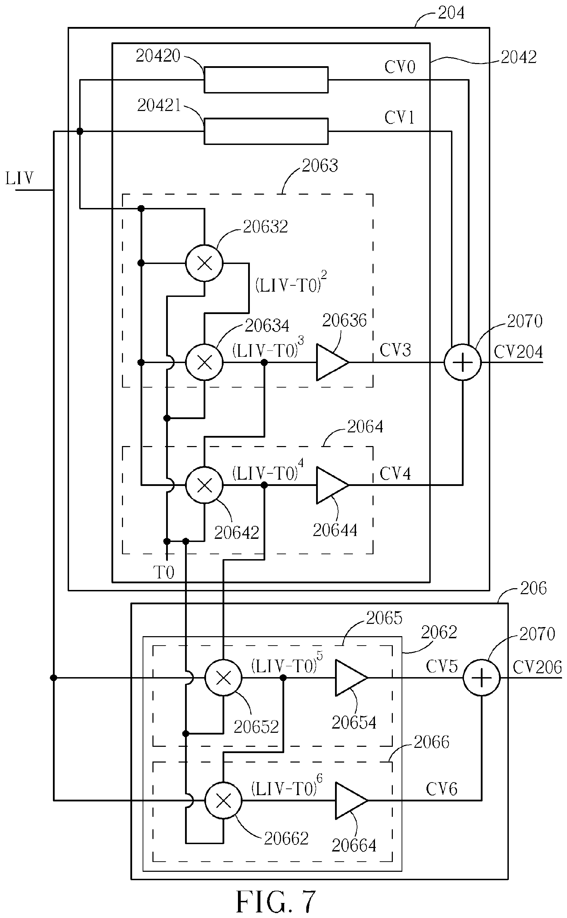

Please refer to FIG. 7. FIG. 7 is a diagram illustrating a first compensation unit group 2042 and a second compensation unit group 2062 according to another embodiment. The first compensation unit group 2042 includes the zeroth-order compensation unit 20420, the first-order compensation unit 20421, the third-order compensation unit 20623, and the fourth-order compensation unit 20624. The second compensation unit group 2042 includes the fifth-order compensation unit 2065 and a sixth-order compensation unit 2066, where the sixth-order compensation unit 2066 includes a sixth multiplier 20662 and a fourth amplifier 20664. Therefore, a first compensation signal CV204 in FIG. 7 is generated by the first adder 2044 according to equation (5), the zeroth-order compensation signal CV0, the first-order compensation signal CV1, the third-order compensation signal CV3, and the fourth-order compensation signal CV4; and, the second compensation signal CV206 is generated by the second adder 2070 according to equation (6), the fifth-order compensation signal CV5, and a sixth-order compensation signal CV6:

$$CV204 = CV0 + CV1 + COEF1 \times (LIV - T0)^3 + COEF2 \times (LIV - T0)^4 \quad (5)$$

$$CV206 = COEF3 \times (LIV - T0)^5 + COEF4 \times (LIV - T0)^6 \quad (6)$$

In addition, the embodiments in FIG. 3, FIG. 4, FIG. 5, and FIG. 7 are only used for describing that the first compensation unit group 2042 and the second compensation unit group 2062 can be combinations of compensation units of any order. But, the first compensation unit group 2042 and the second compensation unit group 2062 do not include a second-order compensation unit. Therefore, the present invention is not limited to the embodiments in FIG. 3, FIG. 4, FIG. 5, and FIG. 7.

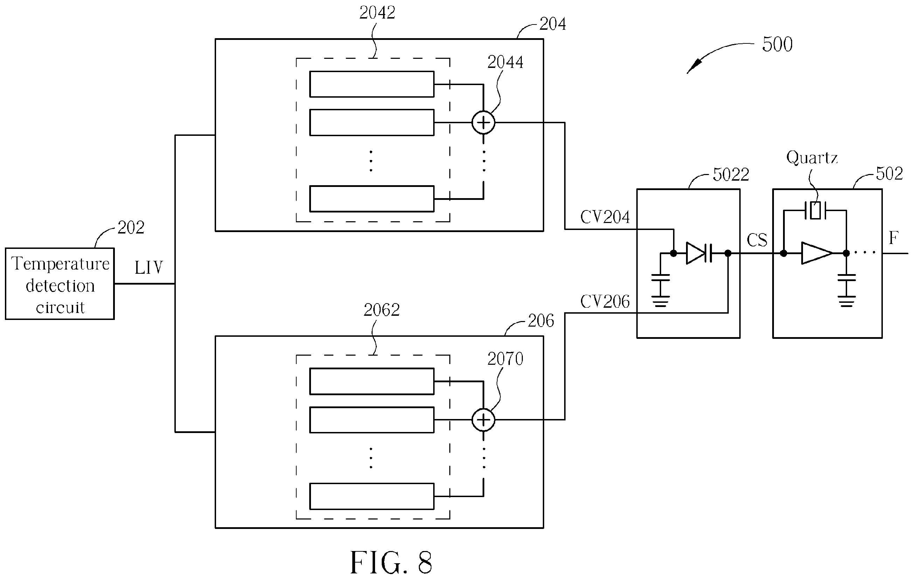

Please refer to FIG. 8. FIG. 8 is a diagram illustrating a frequency calibration system 500 according to another embodiment. The frequency calibration system 500 includes the temperature detection circuit 202, the two compensation circuits 204, 206, and a crystal oscillator 502. The crystal oscillator 502 is used for outputting an oscillation frequency F not influenced by a temperature. Further, subsequent operational principles of the crystal oscillator 502 of the frequency calibration system 500 are the same as those of the crystal oscillator VCXO in FIG. 2, so further descriptions thereof are omitted for simplicity.

Please refer to FIG. 9. FIG. 9 is a diagram illustrating a Gilbert-cell type multiplier. As shown in FIG. 9, after an ith Gilbert-cell type multiplier receives the adjustment parameter signal T0, the input signal LIV, and an (i-1)th signal $(LIV-T0)^i$, the ith Gilbert-cell type multiplier outputs an ith signal $(LIV-T0)^{i+1}$, where the (i-1)th signal $(LIV-T0)^i$ and the ith signal $(LIV-T0)^{i+1}$ are determined by equation (7) and equation (8), respectively:

$$(LIV - T0)^i = (LIV - T0)^i \_P - (LIV - T0)^i \_N \quad (7)$$

$$(LIV - T0)^{i+1} = (LIV - T0)^{i+1} \_P - (LIV - T0)^{i+1} \_N \qquad (8)$$

As shown in FIG. 9, equation (7), and equation (8), $(LIV-T0)^i\_P$ and $(LIV-T0)^i\_N$ are differential signals of the (i-1)th signal $(LIV-T0)^i$, and $(LIV-T0)^{i+1}\_P$ and $(LIV-T0)^{i+1}\_N$ are differential signals of the ith signal $(LIV-T0)^{i+1}$.

To sum up, the frequency calibration system utilizes the at least two compensation circuits to generate the at least two compensation signals for compensating the frequency error of the crystal oscillator that varies with the temperature. The plurality of compensation units included by each compensation circuit of the at least two compensation circuits can be combinations of compensation units of any order. But, the at least two compensation circuits do not include the second-order compensation unit. In addition, the third-order compensation unit or the higher than third-order compensation unit of the at least two compensation circuits are realized by a plurality of multipliers and at least one amplifier. Because the plurality of compensation units included by each compensation circuit of the at least two compensation circuits can be combinations of compensation units of any order, the present invention can easily adjust the at least two compensation circuits to reduce design complexity of the at least two compensation circuits and increase compensation accuracy.

## Claims

1.  A temperature compensated frequency generating system (200) comprising:

    a crystal oscillator (VCXO) for generating an oscillation frequency (F);
    a temperature detection circuit (202) for detecting a temperature and generating a linearly temperature dependent input signal (LIV) at an output;
    at least two temperature compensation circuits (204, 206) coupled to the output of the temperature detection circuit for receiving the input signal (LIV) and generating at least a first group temperature compensation signal (CV204) and a second group temperature compensation signal (CV206) according to the input signal (LIV), respectively, wherein the at least two temperature compensation circuits (204, 206) comprise a first temperature compensation unit group (2042) and a second temperature compensation unit group (2062), the first temperature compensation unit group (2042) comprising:

    a zeroth-order temperature compensation unit (20420) coupled to the input signal (LIV) for outputting a zeroth-order temperature compensation signal (CV0);
    a first-order temperature compensation unit (20421) coupled to the input signal for outputting a first-order temperature compensation signal (CV1); and
    a first adder (2044) coupled to the zeroth-order temperature compensation signal (CV0) and the first-order temperature compensation signal (CV1) for generating the first group temperature compensation signal (CV204) ) not including a second-order temperature compensation component; and the second temperature compensation unit group (2062) comprising:
    an Nth-order temperature compensation unit (2063, 2065 ) coupled to the input signal (LIV) for outputting an Nth-order temperature compensation signal (CV3,CV5) being a component of the second group temperature compensation signal (CV206) consisting of Nth or higher order temperature compensation components, wherein N is greater than 2; and

    a varactor diode (VR) coupled to the at least two temperature compensation circuits (204, 206) to receive the first group temperature compensation signal (CV204) at an anode terminal and the second group temperature compensation signal (CV206) at the cathode terminal, the cathode terminal of the varactor diode (VR) is connected to an input node of the crystal oscillator (VCXO) for determining the oscillation frequency (F).

2.  The temperature compensated frequency generating system (200) of claim 1, wherein the second compensation circuit (206) further comprises:
    a second adder (2070) coupled to the Nth-order temperature compensation signal (CV3) for generating the second group temperature compensation signal (CV206).

3.  The temperature compensated frequency generating system (200) of claim 1, wherein the second temperature compensation circuit (206) further comprises:

a fourth temperature compensation unit (2064) coupled to the input signal (LIV) for outputting a fourth temperature compensation signal (CV4);
a fifth temperature compensation unit (2065) coupled to the input signal (LIV) for outputting a fifth temperature compensation signal (CV5); and
a second adder (2070) coupled to the Nth-order temperature compensation signal (CV3), the fourth temperature compensation signal (CV4), and the fifth temperature compensation signal (CV5) for generating the second group temperature compensation signal (CV206).

4. The temperature compensated frequency generating system (200) of claim 1, wherein the first temperature compensation circuit (204) further comprises:

a sixth temperature compensation unit (20636) coupled to the input signal (LIV) for outputting a sixth temperature compensation signal (CV3);
a seventh temperature compensation unit (2064) coupled to the input signal (LIV) for outputting a seventh temperature compensation signal (CV4); and
the first adder (2044) coupled to the zeroth-order temperature compensation signal (CV0), the first-order temperature compensation signal (CV1), the sixth temperature compensation signal (CV3), and the seventh temperature compensation signal (CV4) for generating the first group temperature compensation signal (CV204).

5. The temperature compensated frequency generating system (200) of claim 4, wherein the second temperature compensation circuit (206) further comprises:

an eighth temperature compensation unit (2066) coupled to the input signal (LIV) for outputting an eighth temperature compensation signal (CV6); and
a second adder (2070) coupled to the Nth-order temperature compensation signal (CV5), and the eighth temperature compensation signal (CV6) for generating the second group temperature compensation signal (CV206).

6. The temperature compensated frequency generating system (200) of claim 3 wherein the Nth-order temperature compensation unit (2063) comprises:

a first multiplier (20632) coupled to the input signal (LIV) and an adjustment parameter signal for outputting a first signal;
a second multiplier (20634) coupled to the input signal (LIV), the first signal, and the adjustment parameter signal for outputting a second signal; and
a first amplifier (20636) coupled to the second signal for outputting the Nth-order temperature compensation signal (CV3).

7. The temperature compensated frequency generating system (200) of claim 3, wherein the Nth-order temperature compensation unit (2063) comprises:

a first multiplier (20632) coupled to the input signal and an adjustment parameter signal for outputting a first signal;
a second multiplier (20634) coupled to the input signal (LIV), the first signal, and the adjustment parameter signal for outputting a second signal; and
a first amplifier (20636) coupled to the second signal for outputting the Nth-order temperature compensation signal; and

the fourth temperature compensation unit (2064) comprises:

a fourth multiplier (20642) coupled to the input signal, the second signal, and the adjustment parameter signal for outputting a third signal; and
a second amplifier (20644) coupled to the third signal for outputting the fourth temperature compensation signal (CV4).

8. The temperature compensated frequency generating system (200) of claim 3 wherein the Nth-order temperature compensation unit (2063) comprises:

a first multiplier (20632) coupled to the input signal (LIV) and an adjustment parameter signal for outputting a first signal;

a second multiplier (20634) coupled to the input signal, the first signal, and the adjustment parameter signal for outputting a second signal; and
a first amplifier (20636) coupled to the second signal for outputting the Nth-order temperature compensation signal (CV3);

the fourth temperature compensation unit (2064) comprises:

a fourth multiplier (20642) coupled to the input signal (LIV), the second signal, and the adjustment parameter signal for outputting a third signal; and
a second amplifier (20644) coupled to the third signal for outputting the fourth temperature compensation signal CV4 and

the fifth temperature compensation unit (2065) comprises:

a fifth multiplier (20652) coupled to the input signal (LIV), the third signal, and the adjustment parameter signal for outputting a fourth signal; and
a third amplifier (20654) coupled to the fourth signal for outputting the fifth temperature compensation signal (CV5).

9. The temperature compensated frequency generating system (200) of claim 5, wherein the sixth temperature compensation unit (2063) comprises:

a first multiplier (20632) coupled to the input signal (LIV) and an adjustment parameter signal for outputting a first signal;
a second multiplier (20634) coupled to the input signal (LIV), the first signal, and the adjustment parameter signal for outputting a second signal; and
a first amplifier (20636) coupled to the second signal for outputting the Nth-order temperature compensation signal (CV3);

the seventh temperature compensation unit (2064) comprises:

a fourth multiplier (20642) coupled to the input signal (LIV), the second signal, and the adjustment parameter signal for outputting a third signal; and
a second amplifier (20644) coupled to the third signal for outputting the fourth temperature compensation signal (CV4);

the Nth-order temperature compensation unit (2065) comprises:

a fifth multiplier (20652) coupled to the input signal (LIV), the third signal, and the adjustment parameter signal for outputting a fourth signal; and
a third amplifier (20654) coupled to the fourth signal for outputting the fifth temperature compensation signal (CV5); and

the eighth temperature compensation unit (2066) comprises:

a sixth multiplier (20662) coupled to the input signal (LIV), the fourth signal, and the adjustment parameter signal for outputting a fifth signal; and
a fourth amplifier (20664) coupled to the fifth signal for outputting the eighth temperature compensation signal (CV6).

10. The temperature compensated frequency generating system (200) of claim 9, wherein the first multiplier (20632), the second multiplier (20634), the fourth multiplier (20642), the fifth multiplier (20652), and the sixth multiplier (20662) are Gilbert-cell type multipliers.

**Patentansprüche**

1. Temperaturkompensiertes Frequenzerzeugungssystem (200), welches umfasst:

einen Quarzoszillator (VCXO) zur Erzeugung einer Schwingungsfrequenz (F);

eine Temperaturerfassungsschaltung (202) zur Erfassung einer Temperatur und zur Erzeugung eines linear temperaturabhängigen Eingangssignals (LIV) an einem Ausgang;

mindestens zwei Temperaturkompensationsschaltungen (204, 206), die mit dem Ausgang der Temperaturerfassungsschaltung gekoppelt sind, um das Eingangssignal (LIV) zu empfangen und mindestens ein erstes Gruppentemperaturkompensationssignal (CV204) bzw. ein zweites Gruppentemperaturkompensationssignal (CV206) entsprechend dem Eingangssignal (LIV) zu erzeugen, worin die mindestens zwei Temperaturkompensationsschaltungen (204, 206) eine erste Temperaturkompensationseinheitengruppe (2042) und eine zweite Temperaturkompensationseinheitengruppe (2062) umfassen, worin die erste Temperaturkompensationseinheitengruppe (2042) umfasst:

eine Temperaturkompensationseinheit nullter Ordnung (20420), die mit dem Eingangssignal (LIV) gekoppelt ist, um ein Temperaturkompensationssignal nullter Ordnung (CV0) auszugeben;

eine Temperaturkompensationseinheit erster Ordnung (20421), die mit dem Eingangssignal gekoppelt ist, um ein Temperaturkompensationssignal erster Ordnung (CV1) auszugeben; und

einen ersten Addierer (2044), der mit dem Temperaturkompensationssignal nullter Ordnung (CV0) und dem Temperaturkompensationssignal erster Ordnung (CV1) gekoppelt ist, um das erste Gruppentemperaturkompensationssignal (CV204) zu erzeugen, das keine Temperaturkompensationskomponente zweiter Ordnung enthält; und

worin die zweite Temperaturkompensationseinheitengruppe (2062) umfasst:
eine Temperaturkompensationseinheit (206, 2065) n-ter Ordnung, die mit dem Eingangssignal (LIV) gekoppelt ist, um ein Temperaturkompensationssignal (CV3, CV5) n-ter Ordnung auszugeben, das eine Komponente des zweiten Gruppentemperaturkompensationssignals (CV206) ist, die aus Temperaturkomponenten n-ter oder höherer Ordnung besteht, wobei n größer als 2 ist; und

eine Varaktordiode (VR), die mit den mindestens zwei Temperaturkompensationsschaltungen (204, 206) gekoppelt ist, um das erste Gruppentemperaturkompensationssignal (CV204) an einem Anodenanschluss und das zweite Gruppentemperaturkompensationssignal (CV206) an dem Kathodenanschluss zu empfangen, worin der Kathodenanschluss der Varaktordiode (VR) zum Bestimmen der Oszillationsfrequenz (F) mit einem Eingangsknoten des Quarzoszillators (VCXO) verbunden ist.

2. Temperaturkompensiertes Frequenzerzeugungssystem (200) nach Anspruch 1, worin die zweite Kompensationsschaltung (206) ferner umfasst:
einen zweiten Addierer (2070), der mit dem Temperaturkompensationssignal n-ter Ordnung (CV3) gekoppelt ist, um das zweite Gruppentemperaturkompensationssignal (CV206) zu erzeugen.

3. Temperaturkompensiertes Frequenzerzeugungssystem (200) nach Anspruch 1, worin die zweite Temperaturkompensationsschaltung (206) ferner umfasst:

eine vierte Temperaturkompensationseinheit (2064), die mit dem Eingangssignal (LIV) gekoppelt ist, um ein viertes Temperaturkompensationssignal (CV4) auszugeben;

eine fünfte Temperaturkompensationseinheit (2065), die mit dem Eingangssignal (LIV) gekoppelt ist, um ein fünftes Temperaturkompensationssignal (CV5) auszugeben; und

einen zweiten Addierer (2070), der mit dem Temperaturkompensationssignal n-ter Ordnung (CV3), dem vierten Temperaturkompensationssignal (CV4) und dem fünften Temperaturkompensationssignal (CV5) gekoppelt ist, um das zweite Gruppentemperaturkompensationssignal (CV206) zu erzeugen.

4. Temperaturkompensiertes Frequenzerzeugungssystem (200) nach Anspruch 1, worin die erste Temperaturkompensationsschaltung (204) ferner umfasst:

eine sechste Temperaturkompensationseinheit (20636), die mit dem Eingangssignal (LIV) gekoppelt ist, um ein sechstes Temperaturkompensationssignal (CV3) auszugeben;

eine siebte Temperaturkompensationseinheit (2064), die mit dem Eingangssignal (LIV) gekoppelt ist, um ein siebtes Temperaturkompensationssignal (CV4) auszugeben; und

worin der erste Addierer (2044), mit dem Temperaturkompensationssignal nullter Ordnung (CV0), dem Temperaturkompensationssignal erster Ordnung (CV1), dem sechsten Temperaturkompensationssignal (CV3) und dem siebten Temperaturkompensationssignal (CV4) gekoppelt ist, um das erste Gruppentemperaturkompensationssignal (CV204) zu erzeugen.

EP 2 506 439 B1

5. Temperaturkompensiertes Frequenzerzeugungssystem (200) nach Anspruch 4, worin die zweite Temperaturkompensationsschaltung (206) ferner umfasst:

eine achte Temperaturkompensationseinheit (2066), die mit dem Eingangssignal (LIV) gekoppelt ist, um ein achtes Temperaturkompensationssignal (CV6) auszugeben; und
einen zweiten Addierer (2070), der mit dem Temperaturkompensationssignal n-ter Ordnung (CV5) und dem achten Temperaturkompensationssignal (CV6) gekoppelt ist, um das zweite Gruppentemperaturkompensationssignal (CV206) zu erzeugen.

6. Temperaturkompensiertes Frequenzerzeugungssystem (200) nach Anspruch 3, worin die Temperaturkompensationseinheit (2063) der n-ten Ordnung umfasst:

einen ersten Multiplikator (20632), der mit dem Eingangssignal (LIV) und einem Anpassungsparametersignal zur Ausgabe eines ersten Signals gekoppelt ist;
einen zweiten Multiplikator (20634), der mit dem Eingangssignal (LIV), dem ersten Signal und dem Anpassungsparametersignal gekoppelt ist, um ein zweites Signal auszugeben; und
einen ersten Verstärker (20636), der mit dem zweiten Signal gekoppelt ist, um das Temperaturkompensationssignal n-ter Ordnung (CV3) auszugeben.

7. Temperaturkompensiertes Frequenzerzeugungssystem (200) nach Anspruch 3, worin die Temperaturkompensationseinheit (2063) der n-ten Ordnung umfasst:

einen ersten Multiplikator (20632), der mit dem Eingangssignal und einem Anpassungsparametersignal gekoppelt ist, um ein erstes Signal auszugeben;
einen zweiten Multiplikator (20634), der mit dem Eingangssignal (LIV), dem ersten Signal und dem Anpassungsparametersignal gekoppelt ist, um ein zweites Signal auszugeben; und
einen ersten Verstärker (20636), der mit dem zweiten Signal gekoppelt ist, um das Temperaturkompensationssignal n-ter Ordnung auszugeben; und

worin die vierte Temperaturkompensationseinheit (2064) umfasst:

einen vierten Multiplikator (20642), der mit dem Eingangssignal, dem zweiten Signal und dem Anpassungsparametersignal gekoppelt ist, um ein drittes Signal auszugeben; und
einen zweiten Verstärker (20644), der mit dem dritten Signal gekoppelt ist, um das vierte Temperaturkompensationssignal (CV4) auszugeben.

8. Temperaturkompensiertes Frequenzerzeugungssystem (200) nach Anspruch 3, worin die Temperaturkompensationseinheit (2063) der n-ten Ordnung umfasst:

einen ersten Multiplikator (20632), der mit dem Eingangssignal (LIV) und einem Anpassungsparametersignal gekoppelt ist, um ein erstes Signal auszugeben;
einen zweiten Multiplikator (20634), der mit dem Eingangssignal, dem ersten Signal und dem Anpassungsparametersignal gekoppelt ist, um ein zweites Signal auszugeben; und
einen ersten Verstärker (20636), der mit dem zweiten Signal gekoppelt ist, um das Temperaturkompensationssignal (CV3) der n-ten Ordnung auszugeben;

worin die vierte Temperaturkompensationseinheit (2064) umfasst:

einen vierten Multiplikator (20642), der mit dem Eingangssignal (LIV), dem zweiten Signal und dem Anpassungsparametersignal gekoppelt ist, um ein drittes Signal auszugeben; und
einen zweiten Verstärker (20644), der mit dem dritten Signal gekoppelt ist, um das vierte Temperaturkompensationssignals (CV4) auszugeben; und

worin die fünfte Temperaturkompensationseinheit (2065) umfasst:

einen fünften Multiplikator (20652), der mit dem Eingangssignal (LIV), dem dritten Signal und dem Anpassungsparametersignal gekoppelt ist, um ein viertes Signal auszugeben; und
einen dritten Verstärker (20654), der mit dem vierten Signal gekoppelt ist, um das fünfte Temperaturkompensationssignal (CV5) auszugeben.

9. Temperaturkompensiertes Frequenzerzeugungssystem (200) nach Anspruch 5, worin die Temperaturkompensationseinheit sechster Ordnung (2063) umfasst:

einen ersten Multiplikator (20632), der mit dem Eingangssignal (LIV) und einem Anpassungsparametersignal gekoppelt ist, um ein erstes Signal auszugeben;
einen zweiten Multiplikator (20634), der mit dem Eingangssignal (LIV), dem ersten Signal und dem Anpassungsparametersignal gekoppelt ist, um ein zweites Signal auszugeben; und
einen ersten Verstärker (20636), der mit dem zweiten Signal gekoppelt ist, um das Temperaturkompensationssignal (CV3) der n-ten Ordnung auszugeben;

worin die siebte Temperaturkompensationseinheit (2064) umfasst:

einen vierten Multiplikator (20642), der mit dem Eingangssignal (LIV), dem zweiten Signal und dem Anpassungsparametersignal gekoppelt ist, um ein drittes Signal auszugeben; und
einen zweiten Verstärker (20644), der mit dem dritten Signal gekoppelt ist, um das vierte Temperaturkompensationssignal (CV4) auszugeben;

worin die Temperaturkompensationseinheit (2065) der n-ten Ordnung umfasst:

einen fünften Multiplikator (20652), der mit dem Eingangssignal (LIV), dem dritten Signal und dem Anpassungsparametersignal gekoppelt ist, um ein viertes Signal auszugeben; und
einen dritten Verstärker (20654), der mit dem vierten Signal gekoppelt ist, um das fünfte Temperaturkompensationssignal (CV5) auszugeben; und

worin die achte Temperaturkompensationseinheit (2066) umfasst:

einen sechsten Multiplikator (20662), der mit dem Eingangssignal (LIV), dem vierten Signal und dem Anpassungsparametersignal gekoppelt ist, um ein fünftes Signal auszugeben; und
einen vierten Verstärker (20664), der mit dem fünften Signal gekoppelt ist, um das achte Temperaturkompensationssignal (CV6) auszugeben.

10. Temperaturkompensiertes Frequenzerzeugungssystem (200) nach Anspruch 9, worin der erste Multiplikator (20632), der zweite Multiplikator (20634), der vierte Multiplikator (20642), der fünfte Multiplikator (20652) und der sechste Multiplikator (20662) Multiplikatoren vom Gilbert-Zellen-Typ sind.

## Revendications

1. Système (200) de génération de fréquence à compensation de température comprenant:

un oscillateur à quartz (VCXO) pour générer une fréquence d'oscillation (F);
un circuit de détection de température (202) pour détecter une température et générer un signal d'entrée dépendant linéairement de la température (LIV) au niveau d'une sortie ;
au moins deux circuits de compensation de température (204, 206) couplés à la sortie du circuit de détection de température pour recevoir le signal d'entrée (LIV) et pour générer respectivement au moins un signal de compensation de température de premier groupe (CV204) et un signal de compensation de température de deuxième groupe (CV206) en fonction du signal d'entrée (LIV), lesdits au moins deux circuits de compensation de température (204, 206) comprenant un premier groupe d'unités de compensation de température (2042) et un deuxième groupe d'unités de compensation de température (2062), le premier groupe d'unités de compensation de température (2042) comprenant:

une unité de compensation de température d'ordre zéro (20420) couplée au signal d'entrée (LIV) pour délivrer un signal de compensation de température d'ordre zéro (CV0);
une unité de compensation de température de premier ordre (20421) couplée au signal d'entrée pour délivrer un signal de compensation de température de premier ordre (CV1); et
un premier additionneur (2044) couplé au signal de compensation de température d'ordre zéro (CV0) et au signal de compensation de température de premier ordre (CV1) pour générer le signal de compensation de température de premier groupe (CV204) ne comprenant pas de composant de compensation de température de deuxième ordre; et

le deuxième groupe d'unités de compensation de température (2062) comprenant:
une unité de compensation de température de Nième ordre (2063, 2065) couplée au signal d'entrée (LIV) pour délivrer un signal de compensation de température de Nième ordre (CV3, CV5) qui est un composant du signal de compensation de température de deuxième groupe (CV206) constitué de composants de compensation de température de Nième ordre ou plus, N étant supérieur à 2; et
une diode varactor (VR) couplée auxdits au moins deux circuits de compensation de température (204, 206) pour recevoir le signal de compensation de température de premier groupe (CV204) au niveau d'une borne d'anode et le signal de compensation de température de deuxième groupe (CV206) au niveau de la borne de cathode, la borne de cathode de la diode varactor (VR) étant connectée à un nœud d'entrée de l'oscillateur à quartz (VCXO) pour déterminer la fréquence d'oscillation (F).

2. Système (200) de génération de fréquence à compensation de température selon la revendication 1, le deuxième circuit de compensation (206) comprenant en outre:
un deuxième additionneur (2070) couplé au signal de compensation de température de Nième ordre (CV3) pour générer le signal de compensation de température de deuxième groupe (CV206).

3. Système (200) de génération de fréquence à compensation de température selon la revendication 1, le deuxième circuit de compensation de température (206) comprenant en outre:

une quatrième unité de compensation de température (2064) couplée au signal d'entrée (LIV) pour délivrer un quatrième signal de compensation de température (CV4);
une cinquième unité de compensation de température (2065) couplée au signal d'entrée (LIV) pour délivrer un cinquième signal de compensation de température (CV5); et
un deuxième additionneur (2070) couplé au signal de compensation de température de Nième ordre (CV3), au quatrième signal de compensation de température (CV4) et au cinquième signal de compensation de température (CV5) pour générer le signal de compensation de température de deuxième groupe (CV206).

4. Système (200) de génération de fréquence à compensation de température selon la revendication 1, le premier circuit de compensation de température (204) comprenant en outre:

une sixième unité de compensation de température (20636) couplée au signal d'entrée (LIV) pour délivrer un sixième signal de compensation de température (CV3);
une septième unité de compensation de température (2064) couplée au signal d'entrée (LIV) pour délivrer un septième signal de compensation de température (CV4); et
le premier additionneur (2044) couplé au signal de compensation de température d'ordre zéro (CV0), au signal de compensation de température de premier ordre (CV1), au sixième signal de compensation de température (CV3) et au septième signal de compensation de température (CV4) pour générer le signal de compensation de température de premier groupe (CV204).

5. Système (200) de génération de fréquence à compensation de température selon la revendication 4, le deuxième circuit de compensation de température (206) comprenant en outre:

une huitième unité de compensation de température (2066) couplée au signal d'entrée (LIV) pour délivrer un huitième signal de compensation de température (CV6); et
un deuxième additionneur (2070) couplé au signal de compensation de température de Nième ordre (CV5) et le huitième signal de compensation de température (CV6) pour générer le signal de compensation de température de deuxième groupe (CV206).

6. Système (200) de génération de fréquence à compensation de température selon la revendication 3, l'unité de compensation de température de Nième ordre (2063) comprenant:

un premier multiplicateur (20632) couplé au signal d'entrée (LIV) et à un signal de paramètre de réglage pour délivrer un premier signal;
un deuxième multiplicateur (20634) couplé au signal d'entrée (LIV), au premier signal et au signal de paramètre de réglage pour délivrer un deuxième signal; et

un premier amplificateur (20636) couplé au deuxième signal pour délivrer le signal de compensation de température de Nième ordre (CV3).

7. Système (200) de génération de fréquence à compensation de température selon la revendication 3, l'unité de compensation de température de Nième ordre (2063) comprenant:

un premier multiplicateur (20632) couplé au signal d'entrée et à un signal de paramètre de réglage pour délivrer un premier signal;

un deuxième multiplicateur (20634) couplé au signal d'entrée (LIV), au premier signal et au signal de paramètre de réglage pour délivrer un deuxième signal; et

un premier amplificateur (20636) couplé au deuxième signal pour délivrer le signal de compensation de température de Nième ordre; et

la quatrième unité de compensation de température (2064) comprenant:

un quatrième multiplicateur (20642) couplé au signal d'entrée, au deuxième signal et au signal de paramètre de réglage pour délivrer un troisième signal; et

un deuxième amplificateur (20644) couplé au troisième signal pour délivrer le quatrième signal de compensation de température (CV4).

8. Système (200) de génération de fréquence à compensation de température selon la revendication 3, l'unité de compensation de température de Nième ordre (2063) comprenant:

un premier multiplicateur (20632) couplé au signal d'entrée (LIV) et à un signal de paramètre de réglage pour délivrer un premier signal;

un deuxième multiplicateur (20634) couplé au signal d'entrée, au premier signal et au signal de paramètre de réglage pour délivrer un deuxième signal; et

un premier amplificateur (20636) couplé au deuxième signal pour délivrer le signal de compensation de température de Nième ordre (CV3);

la quatrième unité de compensation de température (2064) comprenant:

un quatrième multiplicateur (20642) couplé au signal d'entrée (LIV), au deuxième signal et au signal de paramètre de réglage pour délivrer un troisième signal; et

un deuxième amplificateur (20644) couplé au troisième signal pour délivrer le quatrième signal de compensation de température (CV4); et

la cinquième unité de compensation de température (2065) comprenant:

un cinquième multiplicateur (20652) couplé au signal d'entrée (LIV), au troisième signal et au signal de paramètre de réglage pour délivrer un quatrième signal; et

un troisième amplificateur (20654) couplé au quatrième signal pour délivrer le cinquième signal de compensation de température (CV5).

9. Système (200) de génération de fréquence à compensation de température selon la revendication 5, la sixième unité de compensation de température (2063) comprenant:

un premier multiplicateur (20632) couplé au signal d'entrée (LIV) et à un signal de paramètre de réglage pour délivrer un premier signal;

un deuxième multiplicateur (20634) couplé au signal d'entrée (LIV), au premier signal et au signal de paramètre de réglage pour délivrer un deuxième signal; et

un premier amplificateur (20636) couplé au deuxième signal pour délivrer le signal de compensation de température de Nième ordre (CV3);

la septième unité de compensation de température (2064) comprenant:

un quatrième multiplicateur (20642) couplé au signal d'entrée (LIV), au deuxième signal et au signal de paramètre de réglage pour délivrer un troisième signal; et
un deuxième amplificateur (20644) couplé au troisième signal pour délivrer le quatrième signal de compensation de température (CV4);

l'unité de compensation de température de Nième ordre (2065) comprenant:

un cinquième multiplicateur (20652) couplé au signal d'entrée (LIV), au troisième signal et au signal de paramètre de réglage pour délivrer un quatrième signal; et
un troisième amplificateur (20654) couplé au quatrième signal pour délivrer le cinquième signal de compensation de température (CV5); et

la huitième unité de compensation de température (2066) comprenant:

un sixième multiplicateur (20662) couplé au signal d'entrée (LIV), au quatrième signal et au signal de paramètre de réglage pour délivrer un cinquième signal; et
un quatrième amplificateur (20664) couplé au cinquième signal pour délivrer le huitième signal de compensation de température (CV6).

10. Système (200) de génération de fréquence à compensation de température selon la revendication 9, le premier multiplicateur (20632), le deuxième multiplicateur (20634), le quatrième multiplicateur (20642), le cinquième multiplicateur (20652) et le sixième multiplicateur (20662) étant des multiplicateurs de type à cellule de Gilbert.

FIG. 1 PRIOR ART

FIG. 2

FIG. 3

FIG. 4

FIG. 5

FIG. 6

FIG. 7

FIG. 8

FIG. 9

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- GB 2121629 A
- JP 8116214 A
- US 20080007363 A1
- US 20060022763 A